# EUROPÄISCHE PATENTSCHRIFT

(11) **EP 0 467 196 B1**
(45) Veröffentlichungstag und Bekanntmachung des Hinweises auf die Patenterteilung: **13.12.1995**
(21) Anmeldenummer: 91111388.4
(22) Anmeldetag: 09.07.1991
(51) Int. Cl.: H03M 1/22, G01D 5/249

(54) **Decodiervorrichtung**
Decoding device
Dispositif de décodage

(30) Priorität: 14.07.1990 DE 4022503
(43) Veröffentlichungstag der Anmeldung: 22.01.1992
(73) Patentinhaber: Dr. Johannes Heidenhain GmbH, D-83292 Traunreut (DE)
(72) Erfinder: Kranitzky, Walter, Dr., W-8220 Traunstein (DE)

(56) Entgegenhaltungen:
- EP-A- 0 116 636

## Beschreibung

Die Erfindung bezieht sich auf eine Vorrichtung zum Decodieren eines Codes gemäß dem Oberbegriff des Anspruches 1.

Aus der Literatur sind zahlreiche Vorrichtungen und Verfahren zum Decodieren von Codes bekannt. Als relevanter Stand der Technik sei von der EP-0 116 636 B1 ausgegangen, in der eine Einrichtung zur optischen Positionsmeßung beschrieben ist, die die Merkmale des Oberbegriffes des Hauptanspruches der vorliegenden Erfindung aufweist.

Der Erfindung liegt die Aufgabe zugrunde, eine Decodierung in sogenannter Echtzeit zu erreichen, das heißt innerhalb einer Periode der maximal möglichen Bitfrequenz.

Diese Aufgabe wird durch eine Vorrichtung mit den Merkmalen des Anspruches 1 gelöst.

Die Vorteile der Vorrichtung liegen darin, daß die Länge des zu decodierenden Codes nicht von Bedeutung ist. Ferner ist das Auslesen von Positionswerten aus einer Vergleichstabelle nicht erforderlich, das verringert den Speicheraufwand und vermeidet dadurch lange Auswertezeiten. Durch Nachlaufeigenschaft ist die Störsicherheit hoch. Eine zweite Spur für die Übertragung eines Taktsignales ist nicht erforderlich. Die Vorrichtung kann als Schaltung vollständig in einem anwenderspezifischen integrierten Schaltkreis (ASIC) integriert werden.

Mit Hilfe von Ausführungsbeispielen soll die Erfindung anhand der Zeichnungen näher erläutert werden.

Es zeigt
- Figur 1: ein Prinzipschaubild der erfindungsgemäßen Vorrichtung und
- Figur 2: ein konkretes Ausführungsbeispiel.

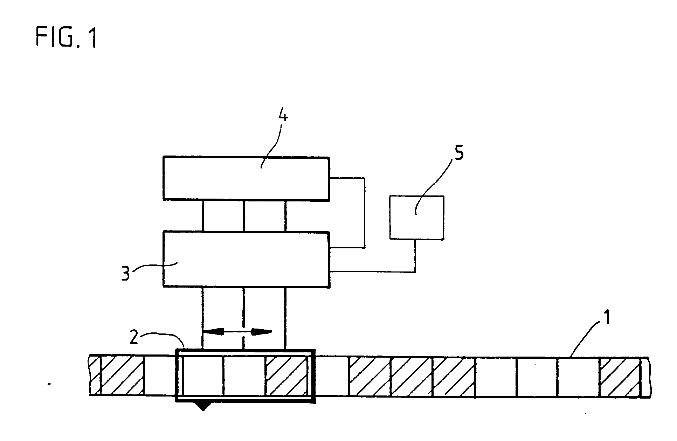

Figur 1 zeigt eine Maßverkörperung 1, auf der ein sogenannter Pseudo Random Code PRC von 3 Bit Länge aufgebracht ist. Damit sind nach allgemeiner Definition 7 Zeichen darstellbar (dezimal 1 bis 7).

Ein Detektorelement 2, das als 3 Bit-Array ausgebildet ist, tastet in Pfeilrichtung den Pseudo Random Code PRC ab. Die Abtastung erfolgt schrittweise, so daß nach und nach 2ⁿ-1=7 Codewörter entstehen.
Das im Beispiel dargestellte - momentan abgetastete Codewort entspricht der dezimalen Zahl "1" und liefert die Signalkombination mit den logischen Zuständen 001. Diese binäre Signalkombination liegt an einem Vergleicher 3 an, der den momentanen Inhalt eines Schieberegisters 4 mit der vom Detektor 2 gelieferten Signalkombination vergleicht.

In Abhängigkeit vom Vergleichsergebnis werden entweder die Inhalte des Schieberegisters 4 und eines Zählers 5 synchron verändert, bis Übereinstimmung mit der Eingangssignalkombination besteht und der Zähler 5 die absolute Position des Detektors 2 relativ zur Maßverkörperung 1 angibt, oder aber Schieberegisterinhalt und Zählerstand werden nicht verändert, weil schon Übereinstimmung besteht.

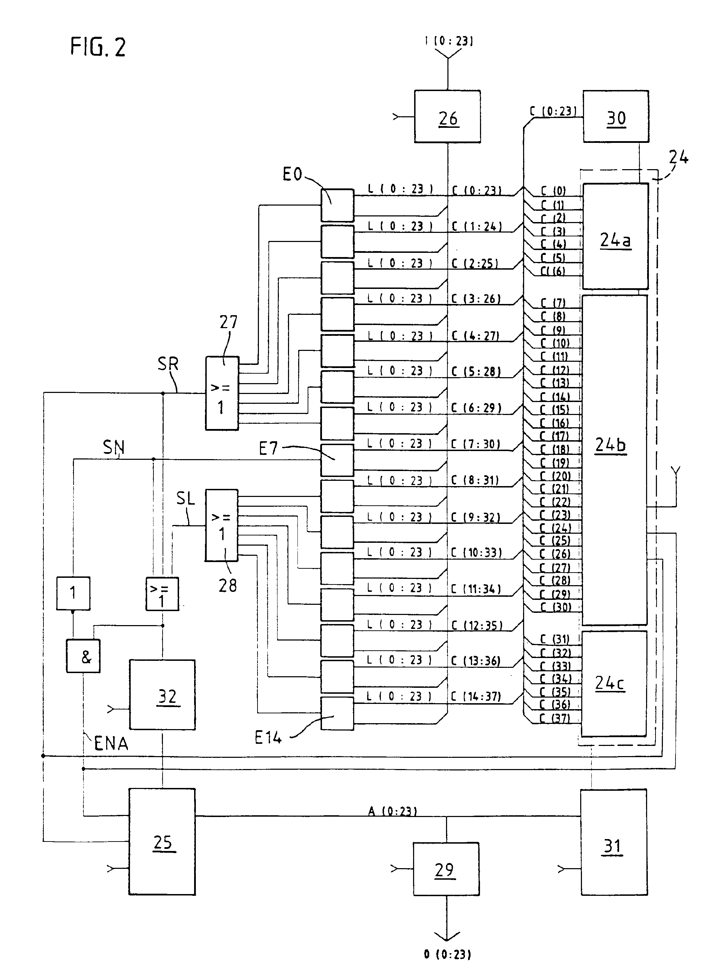

Diese prinzipielle Erläuterung wird durch eine eingehendere Beschreibung anhand der Figur 2 ergänzt.

Für diesen Fall wird ein 24 Bit-PRC angenommen. Vom nicht dargestellten Detektor (der sinngemäß dem aus Figur 1 entspricht, aber 24 Abtastfenster aufweist) werden 24 Signale geliefert, die den zu decodierenden PRC darstellen. Die 24 Signale I (0:23) werden zunächst in einem Speicher 26 gespeichert. Die gespeicherten Signale L (0:23) werden in fünfzehn 24 Bit Vergleichsschaltungen E0 bis E14 mit dem momentanen Inhalt eines Links-/Rechts-Schieberegisters 24 verglichen.

Das Schieberegister 24 besteht aus den Teil-Schieberegistern 24a, 24b und 24c. Die Länge, das heißt die Kapazität des Schieberegisters 24b entspricht der Länge des PRC, hier also 24 Bit. Die Länge der Teil-Schieberegister 24a und 24c beeinflußt die Störfestigkeit der Schaltung und wird durch den Schaltungsaufwand begrenzt.

Die fünfzehn Vergleichsschaltungen E0 bis E14 sind jeweils mit 24 aufeinanderfolgenden Ausgängen des Schieberegisters 24 verbunden.

Die Ausgänge der sieben "oberen" Vergleichsschaltungen E0 bis E6 werden mit einem Oder-Gatter 27 zusammengefaßt, an dessen Ausgang ein Signal SR ansteht. Das Signal SR wird "1", sobald der Eingangscode L (0:23) - der der Abtastsignalkombination I (0:23) entspricht - mit einer der Bitfolgen C (0:23) bis C (6:29) des Schieberegisterinhaltes übereinstimmt.

In gleicher Weise wird mittels eines Oder-Gatters 28 ein Signal SL aus den Vergleichsschaltungen E8 bis E14 gewonnen. Dieses wird "1", sobald der Eingangscode L (0:23) mit einer der Bitfolgen C (8:31) bis C (14:37) des Schieberegisters 24 übereinstimmt.

Mit E7 ist ein Vergleicher bezeichnet, der symmetrisch zwischen den bereits beschriebenen Vergleichern E0 bis E6 und E8 bis E14 liegt. Dessen Ausgangssignal SN wird "1", sobald der Eingangscode L (0:23) mit dem Inhalt C (7:30) des mittleren Schieberegisters 24b übereinstimmt.

Die durch die Vergleicher E0 bis E14 erzeugten Signale SR, SN und SL werden zur synchronen Steuerung des Schieberegisters 24 und eines Zählers 25 verwendet, an die in üblicher Weise auch ein nicht dargestellter Taktgenerator angeschlossen ist. Die Freigabe von Taktimpulsen für den Zähler 25 und das Schieberegister 24 hängt vom Zustand eines Freigabesignales ENA ab, welches wiederum von den binären Zuständen der vorerwähnten vergleichsabhängigen Signalen SR, SN und SL gesteuert wird.

Ist SN gleich "1" oder SN, SR und SL gleichzeitig "0", so wird das Freigabesignal ENA am Schieberegister 24 und am Zähler 25 gleich "0", so daß weder Schiebe- noch Zählvorgänge erfolgen können.

In diesen Fällen entspricht der momentane Eingangscode einer der Bitfolgen C (0:23) bis C (14:37) des Schieberegisters 24 und der damit synchronisierte Zähler repräsentiert mit seinem binären Zählerstand die absolute Position der Maßverkörperung zum Detektorelement.

Wenn das Freigabesignal ENA gleich "1" ist, so legt das Signal SR die Zähl- bzw. die Schieberichtung des Zählers 25 bzw. des Schieberegisters 24 fest. Auf diese Weise wird erreicht, daß sich der Inhalt des Schieberegisters 24 und der Zählerstand des Zählers 25 synchron ändern, bis der Inhalt des Schieberegisters 24b C (7) bis C (30) dem Eingangscode L (0:23) entspricht. Da das Schieberegister 24 und der Zähler 25 synchron gesteuert werden, ist die Beziehung zwischen dem Inhalt des Schieberegisters 24 und dem Zählerstand des Zählers 25 eindeutig.

Die Ausgangssignale A (0:23) des Zählers 25 können in einem Ausgangs-Pufferspeicher 29 gespeichert werden. Sie geben den dem Pseudo Random Code PRC entsprechenden Binärcode wieder.

Es muß zu jedem Zeitpunkt dafür gesorgt werden, daß das Schieberegister 24 eine Bitfolge des Pseudo Random Code PRC enthält. Vor den Schiebevorgängen ist daher das nächstfolgende Bit des PRC an den Eingängen von den Teil-Schieberegistern 24a bzw. 24c bereitzustellen. Während des Rechtsschiebens erhält das Teil-Schieberegister 24a ein Eingangssignal, das über einen PRC-Generator 30 aus einigen der Signale C (0:23) gebildet wird. Da eine ähnliche Funktion für das Linksschieben nicht existiert, wird das Eingangssignal für das Teil-Schieberegister 24c einem Festwertspeicher 31 entnommen. Der Festwertspeicher 31 enthält im einfachsten Fall den gesamten PRC (2²¹ Bit). Die Zuordnung zu den Adressen des Festwertspeichers 31 legt den Offset zwischen PRC und Binärcode fest. Entspricht der Eingangscode keiner der im Schieberegister 24 enthaltenen Bitfolgen, so wird das Freigabesignal ENA deaktiviert.

Somit können kurzzeitig auftretende Fehler im Eingangscode, die von Störsignalen hervorgerufen werden, den Ausgangscode nicht beeinflussen. Nach Abklingen der Störung wird der Ausgangscode dem Eingangscode "nachlaufen" - Der Fangbereich, und damit die maximal zulässige Dauer eines Störsignals, ist durch die Länge der Teil-Schieberegister 24a und 24c bestimmt.

Wird über längere Zeit kein gültiger Eingangscode erkannt, so läuft ein Suchtimer 32 ab und bewirkt im einfachsten Fall ein Setzen aller Zählerbits. Danach wird der gesamte PRC im Linksschiebebetrieb durchlaufen, bis der Inhalt vom Teil-Schieberegister 24b dem Eingangscode entspricht.

In gleicher Weise ist nach dem Einschalten ein einmaliges Durchsuchen des PRC einzuleiten.

Folgende weitere Merkmale verbessern die Eigenschaften der Erfindung, ändern aber nichts am Grundprinzip:
- Paralleles Übertragen des Inhalts des Festwertspeichers 31 in das Schieberegister 24 während des Suchvorganges und der Initialisierung. Dadurch wird die Initialisierungszeit reduziert.
- Intelligente Suchroutinen: Nach Auftreten einer Störung wird zunächst die enge Nachbarschaft des letzten gültigen Codewerts durchsucht. Der Suchbereich wird schrittweise erweitert.
- Aufteilung des Festwertspeichers 31 in ROM- und RAM-Bereiche. Das ROM enthält 24 bit PRCs in großen Abständen. Während des Betriebs wird der jeweils vom Teil-Schieberegister 24c benötigte Teil vom Festwertspeicher 31 mit Hilfe eines zweiten, linear rückgekoppelten Schieberegisters in den RAM-Bereich geschrieben. Auf diese Weise läßt sich der Speicherbedarf wesentlich reduzieren.

## Patentansprüche

1. Vorrichtung zum Decodieren eines Codes, vorzugsweise eines sogenannten Pseudo Random Codes mit n Bits Länge, der mit einem Detektorelement abgetastet wird, mit einem Schieberegister, einem Zähler und wenigstens einer Vergleichsschaltung, wobei das Schieberegister mit dem Zähler synchronisiert ist, und deren Eingänge mit der Vergleichsschaltung verbunden sind, dadurch gekennzeichnet, daß die Vergleichsschaltung aus k (k>3) Vergleichsschaltungen (E0 bis E14) besteht, die je über n Vergleichskanäle verfügen und daß die vom Detektorelement (2) ermittelten n Signale parallel den k n-Bit-Vergleichsschaltungen (E0 bis E14) zum Vergleich mit dem Inhalt des Schieberegisters (24) zugeführt werden.

2. Vorrichtung nach Anspruch 1, dadurch gekennzeichnet, daß jeder Vergleichsschaltung (E0 bis E14) die zu decodierende Abtastsignalkombination (L(0:23)) wie auch der im Schieberegister (24) momentan abgespeicherte Inhalt z.B. (C(0:23 bis C (6:29)) in seiner gesamten Länge angeboten wird.

3. Vorrichtung nach Anspruch 1, dadurch gekennzeichnet, daß das Schieberegister (24) wenigstens eine Länge von n+2 Bits aufweist.

4. Vorrichtung nach Anspruch 1, dadurch gekennzeichnet, daß das Detektorelement (2) als Abtastarray mit n Abtastfeldern ausgebildet ist.

## Claims

1. A device for decoding a code, especially a so-called pseudo-random code of length **n** bits, which is sensed by a detector element, with a shift register, a counter and at least one comparator circuit, wherein the shift register is synchronised with the counter and their inputs are connected to the comparator circuit, characterized in that the comparator circuit consist of **k** (**k** > 3) comparator circuits (E0 to E14) which each have **n** comparison channels and in that the **n** signals detected by the detector element (2) are applied in parallel to the **k n**-bit comparator circuits (E0 to E14) for comparison with the contents of the shift register (24).

2. A device according to claim 1, characterized in that the sensed signal combination (L(0:23)) to be decoded and the instantaneously stored contents of the shift register, e.g. (C(0:23) to C(8:29)) are applied over its full length to each comparator circuit (E0 to E14).

3. A device according to claim 1, characterized in that the shift register (24) has a length of at least **n** + **2** bits.

4. A device according to claim 1, characterized in that the detector element (2) is in the form a sensor array with **n** sensing fields.

## Revendications

1. Dispositif pour le décodage d'un code, de préférence un code pseudo-aléatoire d'une longueur de **n** bits, qui est lu à l'aide d'un élément détecteur, comprenant un registre à décalage, un compteur et au moins un circuit de comparaison, le registre à décalage étant synchronisé avec le compteur et ses entrées étant reliées au circuit de comparaison, caractérisé par le fait que le circuit de comparaison se compose de **k** (**k**>3) circuits de comparaison (E0 à E14) qui disposent chacun de **n** canaux de comparaison et que les **n** signaux déterminés par l'élément détecteur (2) sont appliqués en parallèle aux **k** circuits de comparaison à **n** bits (E0 à E14) en vue de la comparaison avec le contenu du registre à décalage (24).

2. Dispositif suivant la revendication 1, caractérisé par le fait qu'à chaque circuit de comparaison (E0 à E14) sont appliqués la combinaison de signaux d'exploration (L(0:23)) à décoder ainsi que le contenu momentanément mémorisé dans le registre à décalage (24), par exemple C(0:23) à C(6:29) dans toute sa longueur.

3. Dispositif suivant la revendication 1, caractérisé par le fait que le registre à décalage (24) présente au moins une longueur de **n+2** bits.

4. Dispositif suivant la revendication 1, caractérisé par le fait que l'élément détecteur (2) est réalisé sous forme de matrice de lecture à **n** champs de lecture.
